# EUROPÄISCHE PATENTSCHRIFT

(11) **EP 0 461 550 B1**
(45) Veröffentlichungstag und Bekanntmachung des Hinweises auf die Patenterteilung: **04.09.1996**
(21) Anmeldenummer: 91109321.9
(22) Anmeldetag: 07.06.1991
(51) Int. Cl.: H03K 17/945, H03K 17/18

(54) **Elektronisches Schaltgerät mit Zustandsindikator**
Electronic switching apparatus with state indicator
Appareil de commutation électronique avec indicateur d'état

(30) Priorität: 11.06.1990 DE 4018680; 24.07.1990 DE 4023529; 08.04.1991 DE 4111297
(43) Veröffentlichungstag der Anmeldung: 18.12.1991
(73) Patentinhaber: i f m electronic gmbh, D-45127 Essen (DE)
(72) Erfinder: Bürgel, Johannes, W-7992 Tettnang (DE); Lamarche, Jean-Luc, W-7994 Langenargen (DE); Schiff, Andreas, W-7991 Eriskirch (DE); Westrup, Klaus-Peter, W-7778 Markdorf (DE)
(74) Vertreter: Gesthuysen, Hans Dieter, Dipl.-Ing.

(56) Entgegenhaltungen:
- EP-A- 0 049 795
- EP-A- 0 132 850
- EP-A- 0 244 311
- FR-A- 2 065 249

## Beschreibung

Die Erfindung betrifft einen induktiven, kapazitiven oder optoelektronischen Näherungsschalter, mit einem von außen mittels eines Beeinflussungselements beeinflußbaren Oszillator, mit einem dem Oszillator nachgeordneten Schaltverstärker, mit einem von dem Oszillator über den Schaltverstärker steuerbaren elektronischen Schalter, z. B. einem Transistor, einem Thyristor oder einem Triac, und mit einem Zustandsindikator, wobei der Oszillator dann den Schaltzustand des elektronischen Schalters umsteuert, wenn der Beeinflussungszustand des Oszillators eine vorgegebene Ansprechschwelle überschreitet oder unterschreitet, und wobei durch den Zustandsindikator unterschiedliche Beeinflussungszustände des Oszillators bzw. unterschiedliche Schaltzustände des elektronischen Schalters angezeigt werden.

Näherungsschalter der hier grundsätzlich in Rede stehenden Art, die berührungslos arbeiten und kontaktlos ausgeführt sind, werden seit nunmehr etwa zwanzig Jahren in zunehmendem Maße anstelle von elektrischen, mechanisch betätigten Schaltgeräten, die kontaktbehaftet ausgeführt sind, verwendet, insbesondere in elektrischen bzw. elektronischen Meß-, Steuer- und Regelreisen. Mit solchen Näherungsschaltern wird indiziert, ob sich ein Beeinflussungselement, für das der entsprechende Näherungsschalter sensitiv ist, dem Näherungsschalter hinreichend weit genähert hat. Hat sich nämlich ein Beeinflussungselement, für das der entsprechende Näherungsschalter sensitiv ist, dem Näherungsschalter hinreichend weit genähert, so steuert der einen wesentlichen Bestandteil des Näherungsschalters bildende Oszillator den elektronischen Schalter um; bei einem als Schließer ausgeführten Näherungsschalter wird der nichtleitende elektronische Schalter nunmehr leitend, während bei einem als Öffner ausgeführten Näherungsschalter der leitende elektronische Schalter nunmehr sperrt. (Mit Näherungsschaltern der in Rede stehenden Art kann auch indiziert werden, ob eine physikalische Größe eines Beeinflussungsmediums, für die der Näherungsschalter sensitiv ist, einen entsprechenden Wert überschreitet oder unterschreitet.)

Wesentlicher Bestandteil von Näherungsschaltern der zuvor beschriebenen Art ist also u. a. der von außen beeinflußbare Oszillator (vgl. z. B. die deutschen Offenlegungsschriften bzw. Auslegeschriften bzw. Patentschriften 19 51 137, 19 66 178, 19 66 213, 20 36 840, 21 27 956, 22 03 038, 22 03 039, 22 03 040, 22 03 906, 23 30 233, 23 31 732, 23 56 490, 26 13 423, 26 16 265, 26 16 773, 26 28 427, 27 11 877, 27 44 785, 29 43 911, 30 04 829, 30 38 692, 31 20 884, 32 09 673, 32 38 396, 33 20 975, 33 26 440, 33 27 329, 34 20 236, 34 27 498, 34 40 027, 35 19 714, 36 05 499, 37 22 334, 37 22 335, 37 22 336, 37 23 008).

Bei induktiven Näherungsschaltern gilt für den Oszillator, solange ein Metallteil einen vorgegebenen Abstand noch nicht erreicht hat, K V = 1 mit K = Rückkopplungsfaktor und V = Verstärkungsfaktor des Oszillators, d. h. der Oszillator schwingt. Erreicht das entsprechende Metallteil den vorgeschriebenen Abstand, so führt die zunehmende Bedämpfung des Oszillators zu einer Verringerung des Verstärkungsfaktors V, d. h. die Amplitude der Oszillatorschwingung geht zurück bzw. der Oszillator hört auf zu schwingen. Bei kapazitiven Näherungsschaltern gilt für den Oszillator, solange ein Ansprechkörper die Kapazität zwischen einer Ansprechelektrode und einer Gegenelektrode noch nicht erreicht hat, K · V < 1, d. h. der Oszillator schwingt nicht. Erreicht der Ansprechkörper den vorgegebenen Abstand, so führt die steigende Kapazität zwischen der Ansprechelektrode und der Gegenelektrode zu einer Vergrößerung des Rückkopplungsfaktors K, so daß K · V = 1 wird, d. h. der Oszillator beginnt zu schwingen. Bei beiden Ausführungsformen - induktiver Näherungsschalter und kapazitiver Näherungsschalter - wird abhängig von den unterschiedlichen Zuständen des Oszillators der elektronische Schalter, z. B. ein Transistor, ein Thyristor oder ein Triac, gesteuert.

Optoelektronische Näherungsschalter weisen einen Lichtsender und einen Lichtempfänger auf und werden auch als Lichtschranken bezeichnet. Dabei unterscheidet man zwischen einem Lichtschrankentyp, bei dem der Lichtsender und der Lichtempfänger auf entgegengesetzten Seiten einer Überwachungsstrecke angeordnet sind, und einem Lichtschrankentyp, bei dem der Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden Lichtstrahl zum Lichtempfänger zurückreflektiert. In beiden Fällen spricht der Anwesenheitsindikator an, wenn der normalerweise vom Lichtsender zum Lichtempfänger gelangende Lichtstrahl durch ein in die Überwachungsstrecke gelangtes Beeinflussungselement unterbrochen wird. Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurückreflektiert wird.

Im folgenden wird als Beispiel immer ein induktiver Näherungsschalter behandelt. Gleichwohl gelten alle Ausführungen jedoch immer auch für kapazitive und optoelektronische Näherungsschalter.

Ein weiterer wesentlicher Bestandteil von Näherungsschaltern der eingangs und zuvor beschriebenen Art ist der Zustandsindikator, durch den unterschiedliche Beeinflussungszustände des Anwesenheitsindikators bzw. unterschiedliche Schaltzustände des elektronischen Schalters angezeigt werden.

Zunächst sind elektronische, berührungslos arbeitende Näherungsschalter mit einem Zustandsindikator bekannt, bei denen der Zustandsindikator, z. B. als lichtemittierende Diode (LED) ausgeführt, nur die dualen Informationen "Ansprechschwelle unterschritten" und "Ansprechschwelle überschritten" liefert, als lichtemittierende Diode (LED) ausgeführt also nicht leuchtet oder leuchtet. Regelmäßig ist dabei der Zustandsindikator so an den übrigen Näherungsschalter angeschlossen, daß er die dualen Informationen "elektronischer Schalter gesperrt" bzw. "elektronischer Schalter leitend" liefert.

Bei elektronischen Näherungsschaltern der in Rede stehenden Art ist die Ansprechschwelle - leider - keine unabhängig von Umgebungseinflüssen fixierbare Größe. Sie wird vielmehr, ausgehend von einem gewollten und bei der Herstellung mehr oder weniger genau fixierten Wert durch Umgebungseinflüsse verändert, bei induktiven Näherungsschalter z. B. durch Temperatureinflüsse, bei kapazitiven Näherungsschaltern z. B. durch Temperatureinflüsse und durch Feuchtigkeitseinflüsse, bei optoelektronischen Näherungsschaltern z. B. durch Temperatureinflüsse und durch mögliche Verschmutzungen der Optik. Ein dem theoretischen Schaltpunkt benachbarter Bereich - unterhalb und oberhalb des theoretischen Schaltpunktes - gilt deshalb auch als "unsicherer Bereich".

Im übrigen ist ein induktiver Näherungsschalter bekannt (vgl. die DE - A - 34 40 027), bei dem ein Betätigungssimulator mit schalterartigen Mitteln vorgesehen ist, mit denen der ggf. unbedämpfte Oszillator bedämpft und der ggf. bedämpfte Oszillator entdämpft wird. Um den durch das Beeinflussungselement bestimmten Schaltzustand am Ausgang des Näherungsschalters auch dann aufrechtzuerhalten, wenn sich das Beeinflussungselement im Hysteresebereich befindet und gleichzeitig ein Simulationszyklus abläuft, ist vorgesehen, den "künstlich" durch ein Simulationssignal beoder entdämpften Oszillator unmittelbar danach wieder "künstlich" durch ein Rückführungssignal zu ent- oder bedämpfen, so daß der Ausgangszustand vor Beginn der Simulationsphase wiederhergestellt wird.

Schließlich ist ein induktiver Näherungsschalter bekannt (vgl. die EP - A - 0 132 850), bei dem eine Prüfimpulsquelle vorgesehen ist und mit Hilfe von von der Prüfimpulsquelle abgegebener Prüfimpulse in Form bipolarer Doppelimpulse unabhängig vom Schaltzustand des Schaltverstärkers jedes Mal ein kurzfristiges Kippen des Schaltverstärkers herbeigeführt wird. Dabei werden am Ausgang des Schaltverstärkers die überlagerten Prüfimpulse durch eine Prüfschaltung ausgewertet, um eine einwandfreie Funktion des Näherungsschalters zu überwachen.

Der Erfindung liegt nun die Aufgabe zugrunde, den eingangs beschriebenen Näherungsschalter so auszugestalten und weiterzubilden, daß bei seinem Einbau und bei seiner Justage die Problematik "unsicherer Bereich durch Umgebungseinflüsse" berücksichtigt werden kann.

Der erfindungsgemäße Näherungsschalter, bei dem die zuvor hergeleitete und aufgezeigte Aufgabe gelöst ist, ist nun zunächst und im wesentlichen dadurch gekennzeichnet, daß dann und nur dann, wenn sich das Beeinflussungselement bis auf einen vorgegebenen Schaltabstand genähert bzw. von einem vorgegebenen Schaltabstand entfernt hat, wenn also der Oszillator signifikant beeinflußt worden ist, die Schaltabstandeinstellung intern automatisch geändert wird, nämlich der Schaltabstand verringert bzw. vergrößert wird, daß eine durch die Änderung der Schaltabstandeinstellung evtl. auftretende signifikante Änderung des Ausgangssignals des Schaltverstärkers nicht zu einer Änderung des Schaltzustands des elektronischen Schalters führt, daß dann und nur dann, wenn die intern automatisch geänderte Schaltabstandeinstellung zu einer signifikanten Änderung des Ausgangssignals des Schaltverstärkers geführt hat, aus der signifikanten Änderung des Ausgangssignals des Schaltverstärkers der Zustandsindikator oder ein weiterer Zustandsindikator angesteuert wird und daß nach einer vorgegebenen Umschaltzeit die Änderung der Schaltabstandeinstellung wieder rückgängig gemacht wird. Bei dem erfindungsgemäßen Näherungsschalter zeigt der Zustandsindikator oder ein weiterer Zustandsindikator an, ob sich der Beeinflussungszustand des Oszillators, wenn er eine vorgegebene Ansprechschwelle überschritten oder unterschritten hat, in einem "sicheren Bereich" befindet. Dabei meint "sicherer Bereich", daß Umgebungseinflüsse einen vorliegenden Beeinflussungszustand des Oszillators nicht signifikant bzw. einen vorliegenden Schaltzustand des elektronischen Schalters nicht ändern können.

Dadurch, daß bei dem erfindungsgemäßen Näherungsschalter der Zustandsindikator - oder ein weiterer Zustandsindikator - anzeigt, ob sich der Beeinflussungszustand des Oszillators, wenn er eine vorgegebene Ansprechschwelle überschritten oder unterschritten hat, in einem "sicheren Bereich" befindet, ist die Möglichkeit geschaffen, den Näherungsschalter so einzubauen und zu justieren, daß er durch Umgebungseinflüsse nicht anspricht, vielmehr dann und nur dann anspricht, wenn der Beeinflussungszustand des Oszillators durch ein Beeinflussungselement, für das der Oszillator sensitiv geworden ist, gewollt beeinflußt wird.

Im einzelnen gibt es nun verschiedene Möglichkeiten, die zuvor allgemein erläuterte Lehre der Erfindung auszugestalten und weiterzubilden.

Weist bei dem erfindungsgemäßen Näherungsschalter der Oszillator zur Schaltabstandeinstellung einen Schaltabstand-Widerstand oder ein Schaltabstand-Widerstandsnetzwerk auf, so kann durch eine signifikante Beeinflussung des Oszillators der wirksame Widerstandswert des Schaltabstand-Widerstands bzw. des Schaltabstand-Widerstandsnetzwerks geändert werden. Ganz konkret kann das dann, wenn der Oszillator zur Schaltabstandeinstellung ein Schaltabstand-Widerstandsnetzwerk aufweist, dadurch realisiert werden, daß durch eine signifikante Beeinflussung des Oszillators ein Einzelwiderstand des Schaltabstand-Widerstandsnetzwerks kurzgeschlossen wird.

Zuvor ist ausgeführt worden, daß bei dem erfindungsgemäßen Näherungsschalter eine nach der Änderung der Schaltabstandeinstellung evtl. auftretende signifikante Änderung des Ausgangssignals des Schaltverstärkers nicht zu einer Änderung des Schaltzustands des elektronischen Schalters führt. Das kann nur dann, wenn dem elektronischen Schalter eine eine Öffner- oder Schließcharakteristik vorgebende Programmiereinheit vorgeschaltet ist, dadurch realisiert sein, daß dann, wenn nach der Änderung der Schaltabstandeinstellung eine signifikante Änderung des Ausgangssignals des Schaltverstärkers auftritt, die Programmiereinheit umprogrammiert wird.

Im folgenden wird die Erfindung anhand einer lediglich Ausführungsbeispiele darstellenden Zeichnung nochmals erläutert; es zeigt
- Fig. 1: ein Blockschaltbild eines Teils eines ersten Ausführungsbeispiels eines erfindungsgemäßen induktiven Näherungsschalters,
- Fig. 2: eine zu dem Blockschaltbild nach Fig. 1 gehörende schaltungstechnische Realisierung eines Teils eines ersten Ausführungsbeispiels eines erfindungsgemäßen induktiven Näherungsschalters und
- Fig. 3: eine der Fig. 2 entsprechende schaltungstechnische Realisierung eines Teils eines zweiten Ausführungsbeispiels eines erfindungsgemäßen induktiven Näherungsschalters.

In den Figuren ist jeweils nur ein Teil eines erfindungsgemäßen induktiven Näherungsschalters dargestellt. Dargestellt ist nämlich ein von außen beeinflußbarer Oszillator 1, der durch ein sich näherndes bzw. sich entfernendes, nicht dargestelltes Metallteil beeinflußbar ist, ein dem Oszillator 1 nachgeordneter Schaltverstärker 2, zu dem ein Demodulator 3 und ein Schmitt-Trigger 4 gehören, und zwei Zustandsindikatoren 5, 6; nicht dargestellt ist also ein zu dem induktiven Näherungsschalter auch noch gehörender, von dem Oszillator 1 über den Schaltverstärker 2 steuerbarer elektronischer Schalter, bei dem es sich z. B. um einen Transistor, einen Thyristor oder einen Triac handeln kann. Der Oszillator 1 steuert dann den Schaltzustand des nicht dargestellten elektronischen Schalters um, wenn der Beeinflussungszustand des Oszillators 1 eine vorgegebene Ansprechschwelle überschreitet oder unterschreitet, wenn also in den dargestellten Ausführungsbeispielen sich das nicht dargestellte Metallteil bis auf einen vorgegebenen Schaltabstand genähert bzw. von einem vorgegebenen Schaltabstand entfernt hat. Durch den Zustandsindikator 5, bei dem es sich wie bei dem Zustandsindikator 6 um eine LED handelt, werden unterschiedliche Beeinflussungszustände des Oszillators 1 bzw. unterschiedliche Schaltzustände des nicht dargestellten elektronischen Schalters angezeigt.

Der zweite Zustandsindikator 6 zeigt nun an, ob sich der Beeinflussungszustand des Oszillators 1, wenn er eine vorgegebene Ansprechschwelle überschritten oder unterschritten hat, wenn sich also das nicht dargestellte Metallteil bis auf einen vorgegebenen Schaltabstand genähert bzw. von einem vorgegebenen Schaltabstand entfernt hat, in einem "sicheren Bereich" befindet. Dabei meint "sicherer Bereich", wie bereits weiter oben ausgeführt, daß Umgebungseinflüsse einen vorliegenden Beeinflussungszustand des Oszillators 1 nicht signifikant bzw. einen vorliegenden Schaltzustand des nicht dargestellten elektronischen Schalters nicht ändern können.

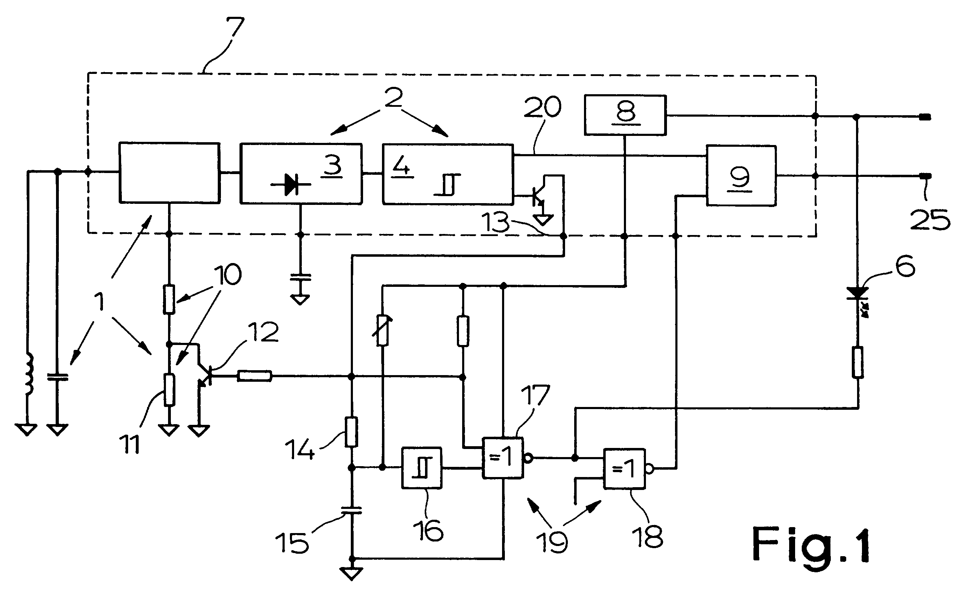

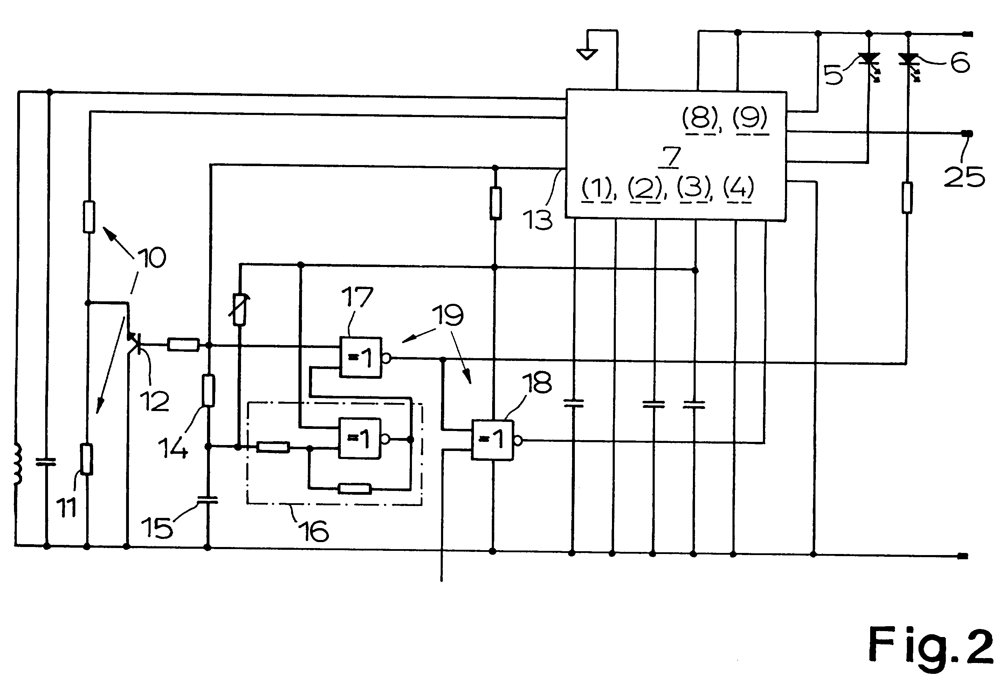

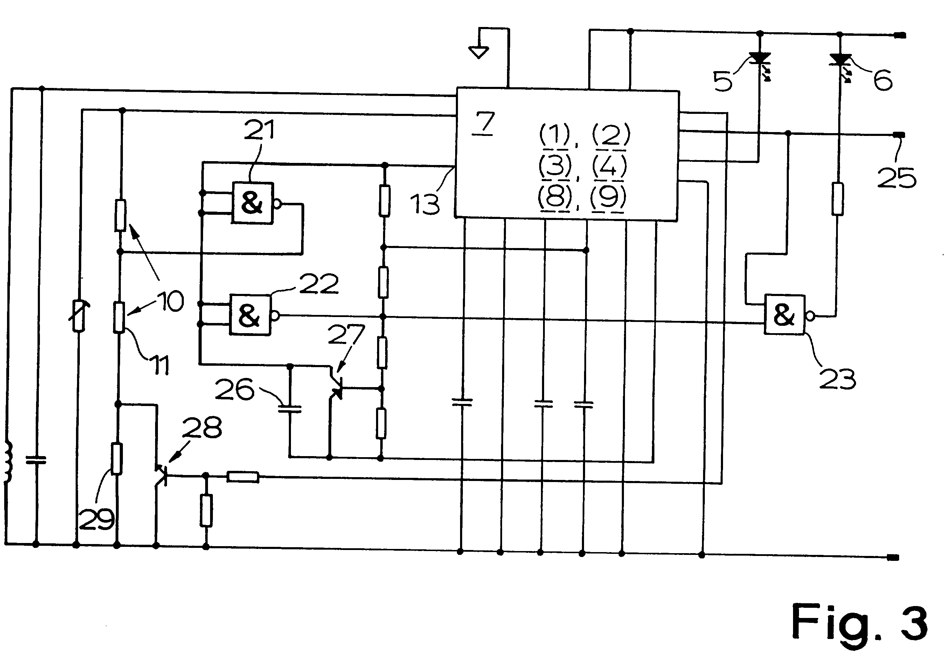

Moderner Technologie entsprechend wird bei dem erfindungsgemäßen Näherungsschalter teilweise mit einem integrierten Schaltkreis, also einem IC 7, gearbeitet. Wie die Fig. 1 zeigt, enthält das IC 7 einen Teil des Oszillators 1, den Schaltverstärker 2 mit dem Demodulator 3 und dem Schmitt-Trigger 4, eine Reglereinheit 8 und eine Programmiereinheit 9; in den Fig. 2 und 3 sind Einzelheiten des IC 7 nicht dargestellt.

Für den in den Figuren dargestellten induktiven Näherungsschalter gilt, daß dann, wenn sich das nicht dargestellte Metallteil bis auf einen vorgegebenen Schaltabstand genähert bzw. von einem vorgegebenen Schaltabstand entfernt hat, wenn also der Oszillator 1 signifikant beeinflußt worden ist, die Schaltabstandeinstellung intern automatisch geändert wird, nämlich der Schaltabstand verringert bzw. vergrößert wird, daß eine nach der Änderung der Schaltabstandeinstellung evtl. auftretende signifikante Änderung des Ausgangssignals des Schaltverstärkers 2 nicht zu einer Änderung des Schaltzustands des nicht dargestellten elektronischen Schalters führt, daß aus der signifikanten Änderung des Ausgangssignals des Schaltverstärkers 2 der Zustandsindikator 6 angesteuert wird und daß nach einer vorgegebenen Umschaltzeit die Änderung der Schaltabstandeinstellung wieder rückgängig gemacht wird.

In den in den Figuren dargestellten Ausführungsbeispielen eines erfindungsgemäßen induktiven Näherungsschalters weist der Oszillator 1 ein Schaltabstand-Widerstandsnetzwerk 10 auf. Dabei wird durch eine signifikante Beeinflussung des Oszillators 1 der wirksame Widerstandswert des Schaltabstand-Widerstandsnetzwerks 10 geändert; es wird nämlich ein Einzelwiderstand 11 des Schaltabstand-Widerstandsnetzwerks 10 kurzgeschlossen, und zwar durch einen vom Ausgang des Schaltverstärkers 2 angesteuerten Schalttransistor 12.

Weiter oben ist bereits darauf hingewiesen worden, daß das IC 7 eine Programmiereinheit 9 aufweist. Die Programmiereinheit 9, die dem nicht dargestellten elektronischen Schalter vorgeschaltet ist, gibt eine Öffner- oder Schließercharakteristik vor. Eine nach der Änderung der Schaltabstandeinstellung auftretende signifikante Änderung des Ausgangssignals des Schaltverstärkers 2 führt deshalb nicht zu einer Änderung des Schaltzustands des nicht dargestellten elektronischen Schalters, weil dann, wenn nach der Änderung der Schaltabstandeinstellung eine signifikante Änderung des Ausgangssignals des Schaltverstärkers 2 auftritt, die Programmiereinheit 9 umprogrammiert wird.

Im folgenden soll nun nochmals die Funktionsweise des in den Figuren dargestellten induktiven Näherungsschalters erläutert werden:

Nähert sich das nicht dargestellte Metallteil bis auf einen vorgegebenen Schaltabstand, dann führt dies zu einer signifikanten Änderung des Ausgangssignals des Schaltverstärkers 2. Dadurch wird einerseits der nicht dargestellte elektronische Schalter umgesteuert, wird andererseits die Schaltabstandeinstellung geändert, nämlich der wirksame Schaltabstand verringert, und zwar dadurch, daß der Einzelwiderstand 11 des Schaltabstand-Widerstandsnetzwerks 10 kurzgeschlossen wird. Ändert sich nun das Ausgangssignal des Schaltverstärkers 2 signifikant, dann wird diese Information in bezug auf den Schaltzustand des nicht dargestellten elektronischen Schalters "unterdrückt"; es wird nämlich die Programmiereinheit 9 umprogrammiert. Gleichzeitig wird der Einzelwiderstand 11 des Schaltabstand-Widerstandsnetzwerks 10 wieder "aktiviert", die zuvor erläuterte Änderung der Schaltabstandeinstellung wird also wieder rückgängig gemacht. Das zuvor erläuterte Funktionsspiel wiederholt sich ständig, so daß der Indikatorausgang 13 des Schaltverstärkers 2 ständig umschaltet. Diese Umschaltung am Indikatorausgang 13 des Schaltverstärkers 2 wird mit Hilfe des Zustandsindikators 6 angezeigt; eine am Indikatorausgang 13 des Schaltverstärkers 2 auftretende, ständig sich wiederholende Umschaltung ist also ein Indiz dafür, daß sich das den Oszillator 1 beeinflussende, nicht dargestellte Metallteil im "unsicheren Bereich" befindet.

Führt die zuvor erläuterte Änderung der Schaltabstandeinstellung nicht zu einer signifikanten Änderung des Ausgangssignals des Schaltverstärkers 2, so tritt am Indikatorausgang 13 des Schaltverstärkers 2 eine Umschaltung nicht auf. Das den Oszillator 1 beeinflussende, nicht dargestellte Metallteil befindet sich also im "sicheren Bereich".

Bei der zuvor erläuterten Arbeitsweise indiziert der Zustandsindikator 6 aktiv den "unsicheren Bereich"; befindet sich das nicht dargestellte Metallteil im "unsicheren Bereich", so leuchtet die als Zustandsindikator 6 vorgesehene LED. Selbstverständlich kann durch eine einfache Inversion auch dafür gesorgt werden, daß dann, wenn sich das nicht dargestellte Metallteil im "sicheren Bereich" befindet, die als Zustandsindikator 6 vorgesehene LED leuchtet.

Im Ausführungsbeispiel nach den Fig. 1 und 2 wird der "unsichere Bereich" unterhalb und oberhalb des theoretischen Schaltpunktes indiziert. Demgegenüber wird im Ausführungsbeispiel nach Fig. 3 nur ein Teil des "unsicheren Bereiches" indiziert, nämlich der unterhalb des theoretischen Schaltpunktes liegende "unsichere Bereich".

Die Figuren zeigen im übrigen Schaltungsdetails, die zuvor nicht beschrieben worden sind, die der Fachmann jedoch ohne weiteres diesen Figuren entnehmen kann. Alle Schaltungsdetails, die die Figuren zeigen, gehören zur Erfindung, auch wenn sie zuvor nicht beschrieben worden sind.

Einige der in den Figuren dargestellten Schaltungsdetails sollen nun noch kurz angesprochen werden:

Führt der Indikatorausgang 13 des Schaltverstärkers 2 das Signal L, so ist der Schalttransistor 12 leitend, der Einzelwiderstand 11 des Schaltabstand-Widerstandsnetzwerks 10 kurzgeschlossen. (In Fig. 1 ist der Schalttransistor 12 "normal betrieben" dargestellt. Im Gegensatz dazu ist in Fig. 2 der Schalttransistor 12 "invers betrieben" dargestellt, wodurch eine geringere Sättigungsspannung erreicht wird.) Sobald am Verbindungspunkt einer am Indiaktorausgang 13 des Signalverstärkers 2 liegenden Reihenschaltung aus einem Ladewiderstand 14 und einem Ladekondensator 15 das Signal L ansteht, führt der Ausgang eines dort mit seinem Eingang angeschlossenen Schmitt-Triggers 16 das Signal L. Der Ausgang des Schmitt-Triggers 16 geht an einen Eingang eines aus zwei NOR-Gattern 17, 18 bestehenden Exklusiv-ODER-Gatters 19, dessen anderer Eingang am Indikatorausgang 13 des Schaltverstärkers 2 liegt. Der Ausgang des Exklusiv-ODER-Gatters 19 liegt an einem Eingang der als Exklusiv-ODER-Gatter ausgeführten Programmiereinheit 9, deren anderer Eingang am Schaltausgang 20 des Schaltverstärkers 2 liegt.

Das, was vorher erläutert worden ist, gilt für einen Teil der in den Fig. 1 und 2 dargestellten Schaltungsdetails. In bezug auf von in Fig. 3 dargestellten Schaltungsdetails noch folgendes:

Bei der in Fig. 3 dargestellten schaltungstechnischen Realisierung eines Teils eines zweiten Ausführungsbeispiels eines erfindungsgemäßen Näherungsschalters ist - statt des gemäß den Fig. 1 und 2 vorgesehenen Schalttransistors 12 - ein NAND-Gatter 21 vorgesehen, dessen Eingänge miteinander verbunden sind, so daß am Ausgang ein gegenüber dem Signal am Eingang inverses Signal entsteht. Die beiden Eingänge des NAND-Gatters 21 liegen am Indikatorausgang 13 des Schaltverstärkers 2. Am Indikatorausgang 13 des Schaltverstärkers 2 liegen auch die beiden miteinander verbundenen Eingänge eines weiteren NAND-Gatters 22, dessen Ausgang mit einem Eingang eines dritten NAND-Gatters 23 verbunden ist. Der zweite Eingang des dritten NAND-Gatters 23 liegt am Schaltgeräteausgang 25, während an den Ausgang des dritten NAND-Gatters 23 die Kathode des als Leuchtdiode ausgeführten zweiten Zustandsindikators 6 angeschlossen ist. Ein an den Indikatorausgang 13 angeschlossener Ladekondensator 26 mit einem parallelgeschalteten Entladetransistor 27, der wieder invers betrieben ist, verhindert, daß das Schaltgerät nicht schaltet. Schließlich ist noch ein - wiederum invers betriebener - Hysteresetransistor 28 vorgesehen, mit dem ein Hysteresewiderstand 29 kurzschließbar ist.

## Patentansprüche

1. Induktiver, kapazitiver oder optoelektronischer Näherungsschalter, mit einem von außen mittels eines Beeinflussungselements beeinflußbaren Oszillator, mit einem dem Oszillator nachgeordneten Schaltverstärker, mit einem von dem Oszillator über den Schaltverstärker steuerbaren elektronischen Schalter, z. B. einem Transistor, einem Thyristor oder einem Triac, und mit einem Zustandsindikator, wobei der Oszillator dann den Schaltzustand des elektronischen Schalters umsteuert, wenn der Beeinflussungszustand des Oszillators eine vorgegebene Ansprechschwelle überschreitet oder unterschreitet, und wobei durch den Zustandsindikator unterschiedliche Beeinflussungszustände des Oszillators bzw. unterschiedliche Schaltzustände des elektronischen Schalters angezeigt werden, **dadurch gekennzeichnet,** daß dann und nur dann, wenn sich das Beeinflussungselement bis auf einen vorgegebenen Schaltabstand genähert bzw. von einem vorgegebenen Schaltabstand entfernt hat, wenn also der Oszillator (1) signifikant beeinflußt worden ist, die Schaltabstandeinstellung intern automatisch geändert wird, nämlich der Schaltabstand verringert bzw. vergrößert wird, daß eine durch die Änderung der Schaltabstandeinstellung evtl. auftretende signifikante Änderung des Ausgangssignals des Schaltverstärkers (2) nicht zu einer Änderung des Schaltzustands des elektronischen Schalters führt, daß dann und nur dann, wenn die intern automatisch geänderte Schaltabstandeinstellung zu einer signifikanten Änderung des Ausgangssignals des Schaltverstärkers (2) geführt hat, aus der signifikanten Änderung des Ausgangssignals des Schaltverstärkers (2) der Zustandsindikator oder ein weiterer Zustandsindikator (6) angesteuert wird und daß nach einer vorgegebenen Umschaltzeit die Änderung der Schaltabstandeinstellung wieder rückgängig gemacht wird.

2. Elektronisches Schaltgerät nach Anspruch 1, wobei der Oszillator zur Schaltabstandeinstellung einen Schaltabstandwiderstand oder ein Schaltabstand-Widerstandsnetzwerk aufweist, dadurch gekennzeichnet, daß durch eine signifikante Beeinflussung des Oszillators (1) der wirksame Widerstandswert des Schaltabstand-Widerstands bzw. des Schaltabstand-Widerstandsnetzwerks (10) geändert wird.

3. Elektronisches Schaltgerät nach Anspruch 2, wobei der Oszillator zur Schaltabstandeinstellung ein Schaltabstand-Widerstandsnetzwerk aufweist, dadurch gekennzeichnet, daß durch eine signifikante Beeinflussung des Oszillators (1) ein Einzelwiderstand (11) des Schaltabstand-Widerstandsnetzwerks (10) kurzgeschlossen wird.

4. Elektronisches Schaltgerät nach einem der Ansprüche 1 bis 3, wobei dem elektronischen Schalter eine eine Öffner- oder Schließercharakteristik vorgebende Programmiereinheit vorgeschaltet ist, dadurch gekennzeichnet, daß dann, wenn nach der Änderung der Schaltabstandeinstellung eine signifikante Änderung des Ausgangssignals des Schaltverstärkers (2) auftritt, die Programmiereinheit (9) umprogrammiert wird.

## Claims

1. An inductive, capacitive or opto-electronic proximity switch, having an oscillator which is externally influenceable by means of an influencing element, having a switching amplifier connected downstream of the oscillator, having an electronic switch, e.g. a transistor, a thyristor or a triac, which can be controlled by the oscillator via the switching amplifier, and having a state indicator, wherein the oscillator reverses the switching state of the electronic switch if the state of influencing of the oscillator exceeds or falls below a predetermined response threshold, and wherein different states of influencing of the oscillator or different switching states of the electronic switch are indicated by the state indicator, **characterised in that** if and only if the influencing element has approached as far as a predetermined switching state or has departed from a predetermined switching state, and therefore if the oscillator (1) has been significantly influenced, the switching distance adjustment is internally automatically altered, namely the switching distance is reduced or increased, that a significant alteration of the output signal of the switching amplifier (2) which possibly arises due to the alteration of the switching distance adjustment does not lead to an alteration of the switching state of the electronic switch, that if and only if the internally automatically altered switching distance adjustment has led to a significant alteration of the output signal of the switching amplifier (2), the state indicator or a further state indicator (6) is triggered from the significant alteration of the output signal of the switching amplifier (2), and that after a predetermined switch-over period the alteration of the switching distance adjustment is cancelled.

2. An electronic switching device according to claim 1, wherein the oscillator comprises a switching distance resistance or a switching distance resistance network for adjusting the switching distance, characterised in that the effective resistance value of the switching distance resistance or of the switching distance resistance network (10) is altered due to a significant influencing of the oscillator (1).

3. An electronic switching device according to claim 2, wherein the oscillator comprises a switching distance resistance network for adjusting the switching distance, characterised in that an individual resistance (11) of the switching distance resistance network (10) is short-circuited due to a significant influencing of the oscillator (1).

4. An electronic switching device according to any one of claims 1 to 3, wherein a programming unit which predetermines a normally closed or normally open characteristic is connected upstream of the electronic switch, characterised in that if a significant alteration of the output signal of the switching amplifier (2) occurs after the alteration of the switching distance adjustment, the programming unit (9) is reprogrammed.

## Revendications

1. Détecteur de proximité inductif, capacitif ou optoélectronique, comprenant un oscillateur influençable de l'extérieur au moyen d'un élément d'influence, un amplificateur de commutation monté à la suite de l'oscillateur, un commutateur électronique qui peut être commandé à partir de l'oscillateur via l'amplificateur de commutation, par exemple un transistor, un thyristor ou un triac, ainsi qu'un indicateur d'état, dans lequel l'oscillateur inverse l'état de commutation du commutateur électronique lorsque l'état d'influence de l'oscillateur dépasse vers le haut ou vers le bas un seuil de réponse prédéfini et dans lequel différents états d'influence de l'oscillateur, respectivement différents états de commutation du commutateur électronique sont indiqués par l'indicateur d'état, caractérisé en ce que lorsque, et uniquement lorsque, l'élément d'influence s'est rapproché jusqu'à une distance de commutation prédéfinie, respectivement s'est éloigné d'une distance de commutation prédéfinie, c'est-à-dire lorsque l'oscillateur (1) a été influencé de manière significative, le réglage de la distance de commutation est modifié automatiquement par voie interne, notamment la distance de commutation diminue, respectivement augmente, en ce qu'une modification significative du signal de départ de l'amplificateur de commutation (2) intervenant éventuellement de par la modification du réglage de la distance de commutation, ne donne pas lieu à une modification de l'état de commutation du commutateur électronique, en ce que lorsque, et uniquement lorsque, le réglage de la distance de commutation modifié de manière automatique par voie interne a donné lieu à une modification significative du signal de sortie de l'amplificateur de commutation (2) , à partir de la modification significative du signal de sortie de l'amplificateur de commutation (2), l'indicateur d'état ou un indicateur d'état supplémentaire (6) est amorcé et en ce que, après un temps de commutation prédéfini, la modification du réglage de la distance de commutation est à nouveau annulée.

2. Commutateur électronique selon la revendication 1, dans lequel l'oscillateur présente, pour le réglage de la distance de commutation, une résistance de distance de commutation ou encore un réseau de résistances de distance de commutation, caractérisé en ce que, par une influence significative de l'oscillateur (1), la valeur de résistance effective de la résistance de distance de commutation, respectivement du réseau de résistances de distance de commutation (10), se modifie.

3. Commutateur électronique selon la revendication 2, dans lequel l'oscillateur présente, pour le réglage de la distance de commutation, un réseau de résistances de distance de commutation, caractérisé en ce que, par une influence significative de l'oscillateur (1), une résistance individuelle (11) du réseau de résistances de distance de commutation (10) est court-circuitée.

4. Commutateur électronique selon l'une quelconque des revendications 1 à 3, dans lequel est montée, en amont du commutateur électronique, une unité de programmation qui prédéfinit une caractéristique de contact de rupture ou de contact de travail, caractérisé en ce que, lorsqu'une modification significative du signal de sortie de l'amplificateur de commutation (2) intervient après la modification du réglage de la distance de commutation, l'unité de programmation (9) est reprogrammée.
